# EUROPÄISCHE PATENTANMELDUNG

(11) **EP 1 162 659 A2**
(43) Veröffentlichungstag der Anmeldung: **12.12.2001**
(21) Anmeldenummer: 01111152.3
(22) Anmeldetag: 10.05.2001
(51) Int. Cl.: H01L 23/427

(54) **Einsatz von PCM in Kühlern für elektronische Bauteile**

(30) Priorität: 08.06.2000 DE 10027803; 26.03.2001 DE 10114998
(71) Anmelder: MERCK PATENT GmbH, 64293 Darmstadt (DE)
(72) Erfinder: Neuschütz, Mark, 64285 Darmstadt (DE); Glausch, Ralf, 64367 Mühltal (DE)

(57) **Zusammenfassung**

Die vorliegende Erfindung betrifft den Einsatz von Phasenwechselmaterialien in Vorrichtungen zur Kühlung für elektrische und elektronische Bauteile.

## Beschreibung

Die vorliegende Erfindung betrifft den Einsatz von Phasenwechselmaterialien in Vorrichtungen zur Kühlung für elektrische und elektronische Bauteile.

In technischen Prozessen müssen oft Wärmespitzen oder -defizite vermieden werden, d.h. es muss thermostatisiert werden. Üblicherweise werden dazu Wärmeaustauscher verwendet. Sie können im einfachsten Fall nur aus einem Wärmeleitblech bestehen, das die Wärme abführt und an die Umgebungsluft abgibt, oder auch Wärmeübertragungsmittel enthalten, die die Wärme zunächst von einem Ort oder Medium zu einem anderen transportieren.

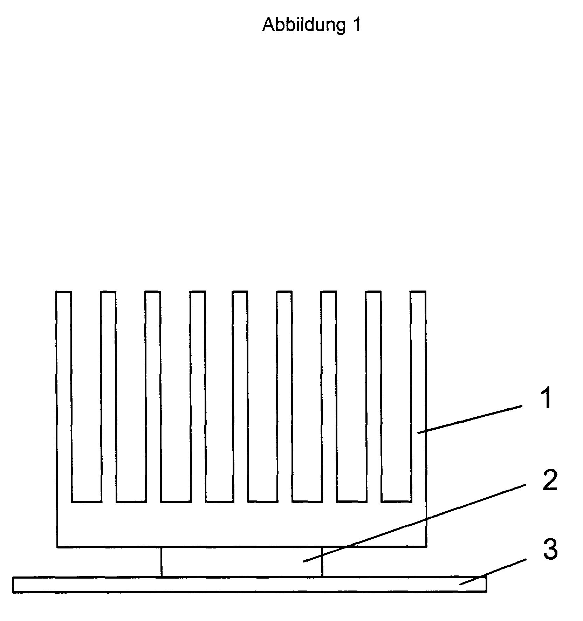

Stand der Technik (Abbildung 1) zur Kühlung elektronischer Bauteile wie z.B. Mikroprozessoren (central processing unit=CPU) (2) sind Kühler aus extrudiertem Aluminium, die die Wärme vom elektronischen Bauelement, welches auf einem Träger (3) aufgebracht ist, aufnehmen und über Kühlrippen (1) an die Umgebung abgeben. Fast immer wird die Konvektion an den Kühlrippen noch durch Lüfter unterstützt.

Diese Art von Kühlern muß immer für den ungünstigsten Fall hoher Außentemperaturen und Volllast des Bauelementes ausgelegt werden, um eine Überhitzung zu verhindern, die die Lebensdauer und Zuverlässigkeit des Bauteils verringern würde. Die maximale Arbeitstemperatur liegt bei den CPUs je nach Bauart zwischen 60 und 90°C.

Im Rahmen der immer schnelleren Taktung von CPUs steigt deren Wärmeabgabe mit jeder neuen Generation sprunghaft an. Während bisher Spitzenleistungen von maximal 30 Watt abgeführt werden mußten, ist in den nächsten 8 bis 12 Monaten mit erforderlichen Kühlleistungen von bis zu 90 Watt zu rechnen. Diese Leistungen können nicht mehr mit den konventionellen Kühlsystemen abgeführt werden.

Für extreme Umgebungsbedingungen wie sie z.B. in ferngelenkten Raketenwaffen auftreten sind Kühler, welche die Abwärme von Elektronischen Bauteilen in Phasenwechselmaterialien z.B. in Form von Schmelzwärme aufnehmen, beschrieben worden (US4673030A, EP116503A, US4446916A). Diese PCM-Kühler dienen dem kurzfristigen Ersatz einer Abfuhr der Energie an die Umgebung und können (und müssen) nicht mehrfach verwendet werden.

Als Speichermedien bekannt sind z.B. Wasser oder Steine/Beton um fühlbare ("sensible") Wärme zu speichern oder Phasenwechselmaterialien (Phase Change Materials, PCM) wie Salze, Salzhydrate oder deren Gemische oder organische Verbindungen (z.B. Paraffin) um Wärme in Form von Schmelzwärme ("latenter" Wärme) zu speichern.

Es ist bekannt, dass beim Schmelzen einer Substanz, d.h. beim Übergang von der festen in die flüssige Phase, Wärme verbraucht, d.h. aufgenommen wird, die, solange der flüssige Zustand bestehen bleibt, latent gespeichert wird, und dass diese latente Wärme beim Erstarren, d.h. beim Übergang von der flüssigen in die feste Phase, wieder frei wird.

Grundsätzlich ist für das Laden eines Wärmespeichers eine höhere Temperatur erforderlich als beim Entladen erhalten werden kann, da für den Transport/Fluss von Wärme eine Temperaturdifferenz erforderlich ist. Die Qualität der Wärme ist dabei von der Temperatur, bei der sie wieder zur Verfügung steht, abhängig: Je höher die Temperatur ist, desto besser kann die Wärme abgeführt werden. Aus diesem Grund ist es erstrebenswert, dass das Temperaturniveau bei der Speicherung so wenig wie möglich absinkt.

Bei sensibler Wärmespeicherung (z.B. durch Erhitzen von Wasser) ist mit dem Eintrag von Wärme eine stetige Erhitzung des Speichermaterials verbunden (und umgekehrt beim Entladen), während latente Wärme bei der Schmelztemperatur des PCM gespeichert und entladen wird. Latente Wärmespeicherung hat daher gegenüber sensibler Wärmespeicherung den Vorteil, dass sich der Temperaturverlust auf den Verlust beim Wärmetransport vom und zum Speicher beschränkt.

Bislang werden als Speichermedium in Latentwärmespeichern üblicherweise Substanzen eingesetzt, die im für die Anwendung wesentlichen Temperaturbereich einen fest-flüssig-Phasenübergang aufweisen, d.h. Substanzen, die bei der Anwendung schmelzen.

So ist aus der Literatur die Verwendung von Paraffinen als Speichermedium in Latentwärmespeichern bekannt. In der Internationalen Patentanmeldung WO 93/15625 werden Schuhsohlen beschrieben, in denen PCM-haltige Mikrokapseln enthalten sind. Dabei werden als PCM entweder Paraffine oder kristallines 2,2,-Dimethyl-1,3-propandiol bzw. 2-Hydroxymethyl-2-methyl-1,3-propandiol vorgeschlagen. In der Anmeldung WO 93/24241 sind Gewebe beschrieben, die mit einem Coating, das derartige Mikrokapseln und Bindemittel enthält, beschichtet sind. Vorzugsweise werden hier paraffinische Kohlenwasserstoffe mit 13 bis 28 Kohlenstoffatomen eingesetzt. In dem Europäischen Patent EP-B-306 202 sind Fasern mit Wärmespeichereigenschaften beschrieben, wobei das Speichermedium ein paraffinischer Kohlenwasserstoff oder ein kristalliner Kunststoff ist und das Speichermaterial in Form von Mikrokapseln in das Fasergrundmaterial integriert ist.

In dem US-Patent US 5 728 316 werden Salzgemische auf Basis von Magnesium- und Lithiumnitrat zur Speicherung und Nutzung von Wärmeenergie empfohlen. Die Wärmespeicherung erfolgt dabei in der Schmelze oberhalb der Schmelztemperatur von 75°C.

Bei den genannten Speichermedien in Latentwärmespeichern erfolgt während der Anwendung ein Übergang in den flüssigen Zustand. Damit sind Probleme beim technischen Einsatz der Speichermedien in Latentwärmespeichern verbunden, da grundsätzlich eine Versiegelung oder Verkapselung erfolgen muss, die einen Flüssigkeitsaustritt, der zu Substanzverlust bzw. Verunreinigung der Umgebung führt, verhindert. Dies erfordert gerade beim Einsatz in oder auf flexiblen Gebilden, wie beispielsweise Fasern, Geweben oder Schäumen in der Regel eine Mikroverkapselung der Wärmespeichermaterialien.

Darüber hinaus steigt der Dampfdruck vieler potentiell geeigneter Verbindungen beim Schmelzen stark an, so dass die Flüchtigkeit der Schmelzen einer Langzeitanwendung der Speichermaterialien oft entgegensteht. Beim technischen Einsatz von schmelzenden PCM entstehen häufig Probleme durch starke Volumenveränderungen beim Aufschmelzen vieler Substanzen.

Daher wird ein neues Gebiet der Phasenwechselmaterialien mit einem besonderen Fokus versehen. Es geht hierbei um fest/fest Phasenwechselmaterialien. Da diese Substanzen während der gesamten Anwendung fest bleiben, entfällt das Erfordernis der Verkapselung. Ein Verlust des Speichermediums oder eine Verunreinigung der Umgebung durch die Schmelze des Speichermediums in Latentwärmespeichern kann so ausgeschlossen werden. Diese Gruppe der Phasenwechselmaterialien erschließt viele neue Anwendungsgebiete.

US 5831831A, JP 10135381A und SU 570131A beschreiben den Einsatz ähnlicher PCM-Kühler im nicht-militärischen Einsatz. Gemeinsam ist den Erfindungen der Verzicht auf konventionelle Kühler (z.B. mit Kühlrippen und Lüfter).

Die oben beschriebenen PCM-Kühler sind nicht geeignet, die Spitzenleistung von Bauelementen mit unregelmäßigem Leistungsprofil abzufangen, da sie keine optimierte Entladung des PCM gewährleisten bzw. auch die Grundlast aufnehmen.

Aufgabe ist es, elektronische und elektrische Bauteile effektiv zu Kühlen und Temperaturspitzen abzufangen.

Gelöst wird die Aufgabe durch Vorrichtungen zum Kühlen von Wärme erzeugenden elektrischen und elektronischen Bauteilen mit ungleichmäßigem Leistungsprofil, bestehend im wesentlichen aus einer wärmeleitenden Einheit und einer Wärme aufnehmenden Einheit, welche ein Phasenwechselmaterial (PCM) enthält.

Gegenstand dieser Erfindung sind Vorrichtungen zur Kühlung elektrischer und elektronischer Bauteile (Mikroprozessoren in Desktop und Laptop Computern sowohl auf Motherboard als auch Grafikkarte, Netzteilen und anderen Bauelementen, die während des Betriebes Wärme abgeben), die ein ungleichmäßiges Leistungsprofil aufweisen.

Vorrichtungen zur Kühlung sind z.B. Kühler. Konventionelle Kühler können durch den Einsatz von PCMs verbessert werden, wenn der Wärmestrom vom elektronischen Bauelement zum Kühler nicht unterbrochen wird. Eine Unterbrechung in diesem Sinne liegt dann vor, wenn das PCM aufgrund der Bauart des Kühlers zunächst die Wärme aufnehmen muß, bevor die Wärme über die Kühlrippen abgeführt werden kann - was zu einer Verschlechterung der Leistung des Kühlers bei gegebener Bauart führt.

Um zu gewährleisten, daß das PCM nur die Leistungsspitzen aufnimmt, gibt es verschiedene Möglichkeiten.

Üblicherweise werden zur Kühlung elektrischer und elektronischer Bauteile Kühler (Abbildung 1) mit Kühlrippen verwendet.

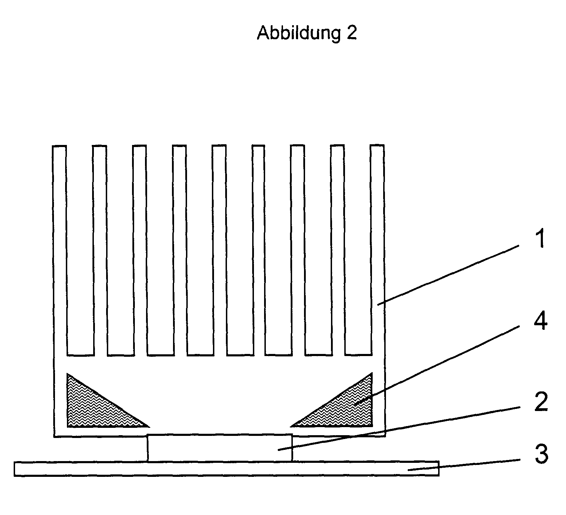

Es wurde gefunden, daß es vorteilhaft ist, das PCM so im oder am Kühler anzuordnen, daß ein signifikanter Wärmestrom zum PCM erst dann stattfindet, wenn der Kühler die Phasenwechseltemperatur T_{PC} des PCM überschreitet (Abbildung 2, Abbildung 3, Abbildung 4 und Abbildung 5).

Es wurde gefunden, daß bei Erreichen dieser Temperatur die Kühlleistung der Kühlrippen noch durch die Wärmeaufnahme des PCM ergänzt wird. Dadurch steigt die Leistung des Kühlers sprunghaft an. Damit wird erreicht, daß das elektrische oder elektronische Bauteil nicht überhitzt wird.

Durch den Einsatz von PCMs in der erfindungsgemäßen Weise können Kühler mit geringerer Leistung verwendet werden, da keine extremen Wärmespitzen abgeführt werden müssen.

Es wurde gefunden, daß Phasenwechselmaterialien besonders geeignet sind, deren Phasenwechseltemperatur T_{PC} in geeigneter Weise unterhalb der für das Bauteil kritischen Maximaltemperatur liegt.

In Abhängigkeit von der gewünschten Maximaltemperatur sind alle bekannten PCMs geeignet. Für den Einsatz der PCMs in einem Wärmeträgermedium sind gekapselte Materialien oder fest-fest PCMs geeignet, die im Wärmeträgermedium unlöslich sind.

Nachfolgend wird ein allgemeines Beispiel der Erfindung näher erläutert.

Die erfindungsgemäßen Vorrichtungen werden an einem Beispiel zur Kühlung von CPUs (central processing unit) für Computer beschrieben.

In der erfindungsgemäßen Vorrichtung (Abbildung 2) wird das PCM (4) so im oder am Kühler (1) angeordnet, daß ein signifikanter Wärmestrom von der CPU (2) auf dem Träger (3) zum PCM (4); erst dann stattfindet, wenn der Kühler die Phasenwechseltemperatur T_{PC} des PCM überschreitet. Damit wird gewährleistet, daß das PCM nur die Leistungsspitzen aufnimmt.

Für diese Anwendung stehen verschiedene PCMs zur Verfügung. Es können PCMs verwendet werden, deren Phasenwechseltemperatur zwischen -100°C und 150°C liegen. Für die Anwendung in elektrischen und elektronischen Bauteilen sind PCMs im Bereich von 40°C bis 95°C bevorzugt. Dabei können die Materialien ausgewählt aus der Gruppe der Paraffine (C₂₀-C₄₅), anorganischen Salze, Salzhydrate und deren Gemische, Carbonsäuren oder Zuckeralkohole sein. Eine Auswahl ist in Tabelle 1 zusammengefaßt.

**Tabelle 1**

| Material | Schmelzpunkt [°C] | Schmelzenthalpie [J/g] | Gruppe |
|---|---|---|---|
| Heneicosan | 40 | 213 | Paraffine |
| Docosan | 44 | 252 | Paraffine |
| Tricosan | 48 | 234 | Paraffine |
| Natriumthiosulfat Pentahydrat | 48 | 210 | Salzhydrate |
| Myristinsäure | 52 | 190 | Carbonsäuren |
| Tetracosan | 53 | 255 | Paraffine |
| Hexacosan | 56 | 250 | Paraffine |
| Natriumacetat Trihydrat | 58 | 265 | Salzhydrate |
| Nonacosan | 63 | 239 | Paraffine |
| Natriumhydroxid Monohydrat | 64 | 272 | Salzhydrate |
| Stearinsäure | 69 | 200 | Carbonsäuren |
| Gemisch aus Lithiumnitrat, Magnesiumnitrat Hexahydrat | 75 | 180 | Salzhydrate |
| Trinatriumphosphat Dodecahydrat | 75 | 216 | Salzhydrate |
| Magnesiumnitrat Hexahydrat | 89 | 160 | Salzhydrate |
| Xylit | 93-95 | 270 | Zuckeralkohole |

Außerdem sind fest-fest PCMs ausgewählt aus der Gruppe Diethylammoniumchlorid, Dipropylammoniumchlorid, Dibutylammoniumchlorid, Dipentylammoniumchlorid, Dihexylammoniumchlorid, Dioctylammoniumchlorid, Didecylammoniumchlorid, Didodecylammoniumchlorid, Dioctadecylammoniumchlorid, Diethylammoniumbromid, Dipropylammoniumbromid, Dibutylammoniumbromid, Dipentylammoniumbromid, Dihexylammoniumbromid, Dioctylammoniumbromid, Didecylammoniumbromid, Didodecylammoniumbromid, Dioctadecylammoniumbromid, Diethylammoniumnitrat, Dipropylammoniumnitrat, Dibutylammoniumnitrat, Dipentylammoniumnitrat, Dihexylammoniumnitrat, Dioctylammoniumnitrat, Didecylammoniumnitrat, Dioctylammoniumchlorat, Dioctylammoniumacetat, Dioctylammoniumformiat, Didecylammoniumchlorat, Didecylammoniumacetat, Didecylammonium-formiat, Didodecylammoniumchlorat, Didodecylammoniumformiat, Didodecylammoniumhydrogensulfat, Didodecylammoniumpropionat, Dibutylammonium-2-nitrobenzoat, Diundecylammoniumnitrat und Didodecylammoniumnitrat geeignet.

Für die Anwendung in elektrischen und elektronischen Bauteilen sind PCMs besonders geeignet, deren T_{PC} zwischen 40°C und 95°C liegt, wie z.B. Didecylammoniumchlorid, Didodecylammoniumchlorid, Dioctadecylammoniumchlorid, Diethylammoniumbromid, Didecylammoniumbromid, Didodecylammoniumbromid, Dioctadecylammoniumbromid, Diethylammoniumnitrat, Dioctylammoniumnitrat, Didecylammoniumnitrat und Didodecylammoniumnitrat.

Die PCMs enthalten vorzugsweise neben dem eigentlichen Wärmespeicherungsmaterial mindestens ein Hilfsmittel. Dabei handelt es sich bei dem mindestens einem Hilfsmittel vorzugsweise um eine Substanz oder Zubereitung mit guter thermischer Leitfähigkeit, insbesondere um ein Metallpulver, -granulat oder Graphit. Dabei liegt das Wärmespeicherungsmaterial vorzugsweise in inniger Mischung mit dem Hilfsmittel vor, wobei das gesamte Mittel vorzugsweise entweder als lose Schüttung oder als Formkörper vorliegt. Unter Formkörpern werden dabei insbesondere alle Gebilde verstanden, die sich durch Kompaktierungsmethoden, wie Pelletierung, Tablettierung, Walzenkompaktierung oder Extrusion, herstellen lassen. Dabei können die Formkörper die verschiedensten Raumformen, wie beispielsweise Kugel-, Würfel- oder Quaderform, annehmen. Außerdem können die hier beschriebenen Mischungen oder Formkörper als zusätzliches Hilfsmittel Paraffin enthalten. Paraffin wird insbesondere dann eingesetzt, wenn bei der Anwendung ein inniger Kontakt zwischen dem Mittel zur Speicherung von Wärme und einem Bauteil hergestellt werden soll. Beispielsweise kann so der passgenaue Einbau von Latentwärmespeichern zur Kühlung elektronischer Bauteile erfolgen. Bei der Montage der Wärmespeicher ist die Handhabung insbesondere eines oben beschriebenen Formkörpers einfach, bei der Anwendung schmilzt das Paraffin, verdrängt Luft an den Kontaktflächen und sorgt so für einen engen Kontakt zwischen Wärmespeichermaterial und Bauteil. Vorzugsweise finden derartige Mittel daher Verwendung in Vorrichtungen zur Kühlung von Elektronikbauteilen.

Zudem können Bindemittel, vorzugsweise ein polymeres Bindemittel, als Hilfsmittel enthalten sein. Dabei liegen die Kristallite des Wärmespeicherungsmaterials vorzugsweise in feiner Verteilung in dem Bindemittel vor. Bei den vorzugsweise polymeren Bindemitteln, die enthalten sein können, kann es sich um jegliche Polymere handeln, die sich dem Anwendungszweck entsprechend als Bindemittel eignen. Vorzugsweise ist das polymere Bindemittel dabei ausgewählt aus härtbaren Polymeren oder Polymervorstufen, die wiederum vorzugsweise ausgewählt sind aus der Gruppe, die aus Polyurethanen, Nitrilkautschuk, Chloropren, Polyvinylchlorid, Siliconen, Ethylen-Vinylacetat-Copolymeren und Polyacrylaten besteht. Wie die geeignete Einarbeitung der Wärmespeichrungsmaterialen in diese polymeren Bindemittel erfolgt, ist dem Fachmann auf diesem Gebiet wohl bekannt. Es bereitet ihm keine Schwierigkeiten gegebenenfalls die nötigen Zusatzstoffe, wie beispielsweise Emulgatoren zu finden, die eine solche Mischung stabilisieren.

Für flüssig-fest PCMs werden vorzugsweise zusätzlich Keimbildner, wie z.B. Borax oder verschiedene Metalloxide, eingesetzt.

Neben der Gewährleistung einer guten Wärmeübertragung durch Metalle (Aluminium, Kupfer etc.) oder andere Wärmeleitstrukturen (Metallpulver, Graphit etc.), kann im Kühler die Wärmeübertragung auch in Form einer Heat Pipe realisiert werden (z.B. US 5770903A für Motorkühlung incl. PCM).

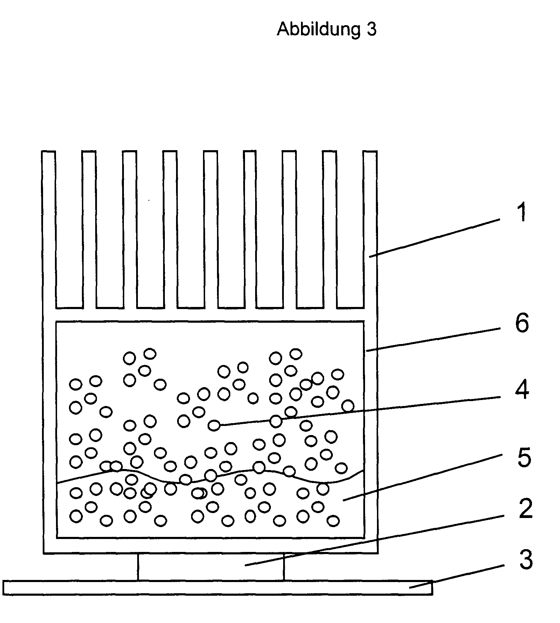

Bei einem Kühler mit Heat Pipe (Abbildung 3) weist das Innere des Kühlers (1) dann z.B. einen Hohlraum (6) auf, der zum Teil mit einem flüssigen und/oder gasförmigen Medium gefüllt ist. Das flüssig/gasförmige Wärmeträgermedium (5) ist ausgewählt aus der Gruppe der Halogenkohlenwasserstoffe (z.B. Ethylbromid, Trichlorethylen, Freone) und deren Äquivalente. Die Gestaltung einer Heat Pipe und die Auswahl eines geeigneten Mediums ist dem Fachmann ohne Probleme möglich.

Neben diesem Medium befinden sich in dem Hohlraum PCM-Partikel (4), die, sobald die Innentemperatur der Heat Pipe die Phasenwechseltemperatur T_{PC} erreicht, Wärme aufnehmen.

Es wurde gefunden, daß verkapselte oder mikroverkapselte PCM's sowie fest-fest PCM's, die im Medium unlöslich sind, besonders geeignet sind. Es können alle bekannten PCMs verwendet werden.

Überraschend wurde gefunden, daß durch die gute Durchmischung der PCM/Medium-Suspension die Dynamik des Kühlers besonders groß ist.

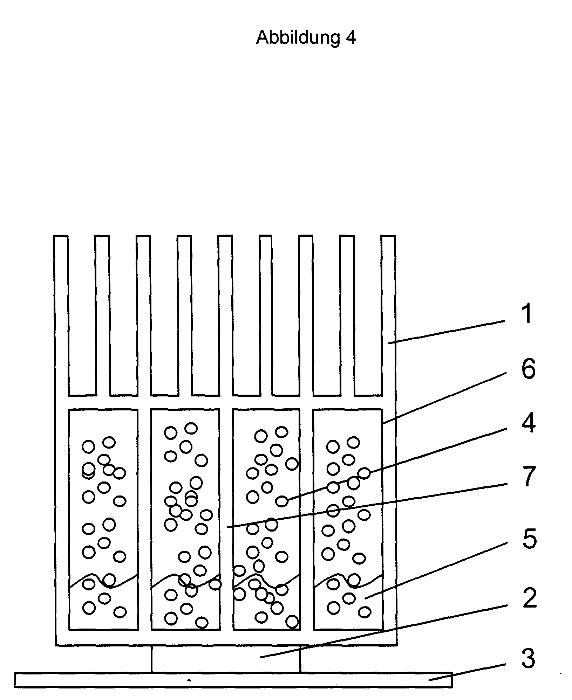

Eine weitere Möglichkeit wurde mit einer Mischform (Abbildung 4) gefunden. Auch hier ist die CPU (2) auf einem Träger (3) aufgebracht. Es werden zur Verbesserung der Wärmeleitung Kühlrippen (7) durch den Hohlraum geführt (6), der wiederum teilweise mit einem flüssig/gasförmigen Wärmeträgermedium (5) gefüllt ist. Vorzugsweise werden durchgehende Kühlrippen verwendet. Wie in der vorhergehenden Varianten befinden sich auch hier neben dem flüssig/gasförmig Wärmeträgermedium in dem Hohlraum PCM-Partikel (4), die, sobald die Innentemperatur der Heat Pipe die Phasenwechseltemperatur T_{PC} erreicht, Wärme aufnehmen.

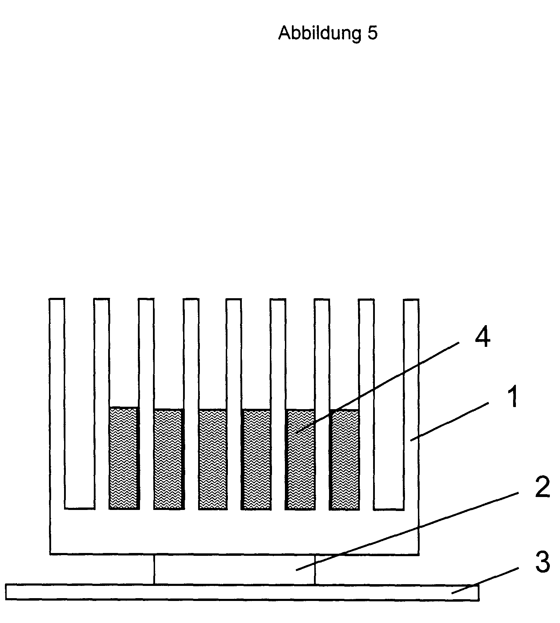

Das PCM kann in beliebige Formen gepreßt werden. Das Material kann in reiner Form verpreßt werden, nach dem Zerkleinern (z.B. Mahlen) gepreßt werden, oder in Mischungen mit anderen Binde- und/oder Hilfsstoffen verpreßt werden. Die Preßlinge können problemlos gelagert, transportiert und vielseitig eingesetzt werden. So können die Preßlinge direkt in elektronische Bauteile eingesetzt werden (Abbildung 5). Auch hier ist die CPU (2) auf einem Träger (3) aufgebracht. Die Preßlinge werden zwischen den Kühlrippen so eingebaut, daß sie in innigem Kontakt mit den Flächen der Kühlrippen stehen. Die Dicke der Preßlinge wird so gewählt, daß zwischen Rippen und Preßling eine kraftschlüssige Verbindung entsteht. Die Preßlinge können auch zwischen Kühlrippen/Wämetauschern eingesetzt werden, bevor diese zu einem Stack verbunden werden.

Diese Arten der Kühlung mit Hilfe von PCMs zum Abfangen von Wärmespitzen sind jedoch nicht auf die Anwendung in Computern beschränkt. Diese Systeme können Anwendung finden in Leistungsschaltungen und Leistungsschaltkreisen für die Mobilkommunikation, Sendeschaltungen für Handys und feste Transmitter, Steuerschaltungen für elektromechanische Stellglieder in der Industrieelektronik und in Kraftfahrzeugen, Hochfrequenzschaltungen für die Satellitenkommunikation und Radar-Anwendungen, Einplatinrechner sowie für Stellglieder und Steuergeräte für Hausgeräte und Industieelektronik.

Diese Vorrichtungen zum Kühlen sind übertragbar auf alle Anwendungen, in denen Wärmespitzen abgefangen werden sollen (z.B. Motoren für Aufzüge, in Umspannwerken, in Verbrennungsmotoren).

**Tabelle 2:**

| Erklärung der Bezeichnungen in den Abbildungen | |
|---|---|
| Bezeichnung | Erklärung |
| 1 | Kühlrippen |
| 2 | central processing unit (CPU) |
| 3 | Träger |
| 4 | Phasenwechselmaterial (PCM) |
| 5 | flüssig/gasförmig Wärmeträgermedium |
| 6 | Hohlraum |
| 7 | Kühlrippen in Hohlraum |
| Z | gesamtes Bauteil |

### Beispiele

### Beispiel 1

Für einen Prozessor, dessen maximale Betriebstemperatur bei 75°C liegt, wird ein Kühler gemäß Abbildung 2 konzipiert. In den Hohlräumen im Kühler wird ein Phasenwechselmaterial mit einer T_{PC} zwischen 60°C und 65°C ausgewählt. Hier wurde Natriumhydroxid Monohydrat mit einer T_{PC} von 64°C verwendet.

### Beispiel 2

Für einen Prozessor mit einer maximalen Betriebstemperatur von 75°C wird eine Kühler gemäß Abbildung 3 konzipiert. In den Hohlräumen des Kühlers befindet sich Trichlorethylen als Wärmeträgerflüssigkeit. Das verwendete PCM ist ein verkapseltes Paraffin. Es wird Nonacosan verwendet, das eine T_{PC} von 63°C hat. Als Phasenwechselmaterial kommen hier jedoch auch fest-fest PCMs in Betracht. Für diesen Prozessor ist Didodecylammoniumnitrat geeignet, da es eine T_{PC} von 66°C hat.

## Patentansprüche

1. Vorrichtung zum Kühlen von Wärme erzeugenden elektrischen und elektronischen Bauteilen mit ungleichmäßigem Leistungsprofil, bestehend im wesentlichen aus einer wärmeleitenden Einheit (1) und einer Wärme aufnehmenden Einheit, welche ein Phasenwechselmaterial (PCM) enthält (4).

2. Vorrichtung nach Anspruch 1, **dadurch gekennzeichnet, daß** das PCM so angeordnet ist, daß der Wärmestrom vom elektronischen Bauelement zu der wärmeleitenden Einheit (1) nicht unterbrochen wird und ein signifikanter Wärmestrom zum PCM erst dann stattfindet, wenn die Temperatur der wärmeleitenden Einheit (1) die Phasenwechseltemperatur T_{pc} des PCM überschreitet.

3. Vorrichtung nach mindestens einem der vorstehenden Ansprüche, **dadurch gekennzeichnet, daß** die PCM enthaltende Einheit (4) aus einem odere mehreren Hohlräumen besteht, in welchen das PCM eingebracht ist, wobei die Hohlräume (6) von der Wärme aufnehmenden Einheit (4) gebildet werden.

4. Vorrichtung nach mindestens einem der vorstehenden Ansprüche, **dadurch gekennzeichnet, daß** die PCM enthaltende Einheit (4) zusätzlich ein flüssig/gasförmiges Wärmeträgermedium (5) enthält.

5. Vorrichtung nach Anspruch 4, **dadurch gekennzeichnet, daß** das flüssig/gasförmige Wärmeträgermedium (5) ausgewählt ist aus der Gruppe der Halogenwasserstoffe.

6. Vorrichtung nach einem der Ansprüche 1 bis 5, **dadurch gekennzeichnet, daß** ein fest/fest PCM eingesetzt ist.

7. Vorrichtung nach einem der vorstehenden Ansprüche, **dadurch gekennzeichnet, daß** das PCM verkapselt ist.

8. Vorrichtung nach einem der Ansprüche 1 bis 7, **dadurch gekennzeichnet, daß** die Wärme leitende Einheit (1) Oberflächen vergrößernde Strukturen aufweist.

9. Vorrichtung nach Anspruch 8, **dadurch gekennzeichnet, daß** die Wärme leitende Einheit (1) Kühlrippen aufweist.

10. Bauteil (Z), bestehend im wesentlichen aus einer Kühlvorrichtung gemäß der Ansprüche 1 bis 9 und einem Wärme erzeugenden elektronischen Bauteil (2), wobei die beiden baulichen Einheiten (1), (4) sowie das Bauteil (2) so zueinander angeordnet sind, daß der Wärmefluß zwischen dem Wärme erzeugenden elektronischen Bauteil (2) und der wärmeleitenden Einheit (1) im direkten Kontakt erfolgt.

11. Bauteil (Z) nach Anspruch 10, **dadurch gekennzeichnet, daß** das elektronische Bauteil (2) eine CPU oder ein Speicherchip eines Computers ist.

12. Computer, enthaltend ein Bauteil gemäß Anspruch 10 oder 11.

13. Verwendung einer Vorrichtung nach Anspruch 1 bis 9 oder eines Bauteils gemäß Anspruch 10 oder 11 in Computern und elektronischen Datenverarbeitungssystemen.

14. Verwendung einer Vorrichtung nach Anspruch 1 bis 9 oder eines Bauteils gemäß Anspruch 10 oder 11 in Leistungsschaltungen und Leistungsschaltkreisen für die Mobilkommunikation, Sendeschaltungen für Handys und feste Transmitter, Steuerschaltungen für elektromechanische Stellglieder irrder Industrieelektronik und in Kraftfahrzeugen, Hochfrequenzschaltungen für die Satellitenkommunikation und Radar-Anwendungen, Einplatinrechner sowie für Stellglieder und Steuergeräte für Hausgeräte und Industieelektronik.
